# EUROPEAN PATENT APPLICATION

(11) **EP 0 997 782 A1**
(43) Date of publication of application: **03.05.2000**
(21) Application number: 99121509.6
(22) Date of filing: 28.10.1999
(51) Int. Cl.: G03F 9/00, G03F 7/20

(54) **Reticle having mark for detecting alignment and method for detected alignment**

(30) Priority: 28.10.1998 JP 30677798
(71) Applicant: NEC CORPORATION, Tokyo (JP)
(72) Inventor: Yokota, Kazuki, Minato-ku, Tokyo (JP)
(74) Representative: Betten & Resch

(57) **Abstract**

A reticle comprising a circuit pattern for exposing a wafer to form an exposed circuit pattern at a specified design rule, and an alignment mark (X1, X2, Y1 and Y2) for exposing the wafer to form an exposed alignment mark at said specified design rule. In accordance with the reticle of the present invention, the alignment marks (X1, X2, Y1 and Y2) having the divided minute segments can more accurately detect the misalignment between two layers of a semiconductor wafer compared with a conventional aligning method employing box marks having a much larger size.

## Description

### BACKGROUND OF THE INVENTION

### (a) Field of the Invention

The present invention relates to a reticle having an alignment mark for detecting alignment used in a lithographic step of a semiconductor manufacturing process for improving an accuracy of the alignment between an underlying layer circuit pattern and an overlying layer resist pattern, and to a method for detecting the alignment.

### (b) Description of the Related Art

In a lithographic step for forming an etching pattern by employing a resist conducted in a semiconductor device manufacturing process, it is important to accurately align an overlying layer resist pattern with an underlying layer circuit pattern. Accordingly, a mark for detecting an accuracy of alignment is formed in a marginal area of a wafer separately from the circuit pattern between the underlying layer circuit pattern and the overlying layer resist pattern.

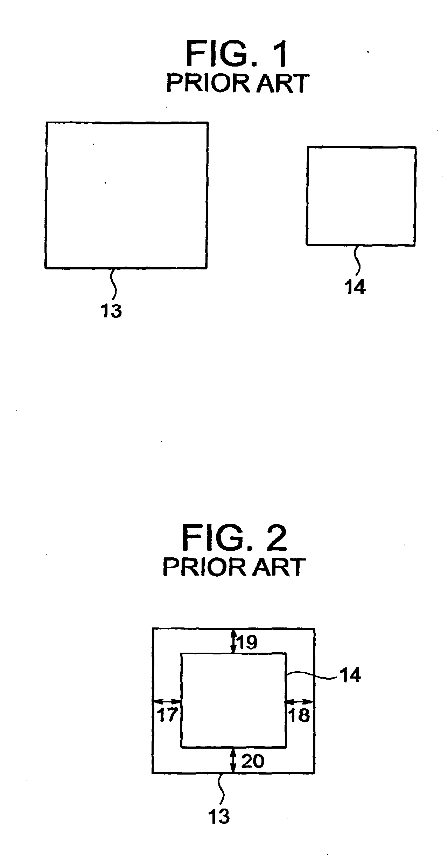

An example of the mark for detecting the accuracy of alignment will be described referring to Figs.1 and 2.

A first box mark 13 is formed as an opening or island in a marginal area during a process of forming the underlying layer circuit pattern, and a second box mark 14 smaller than the first box mark 13 is then formed in the marginal area in alignment with the first box mark 13 by punching or leaving during patterning the overlying layer resist pattern. After the formation of the overlying layer resist pattern, as shown in Fig.2. Amounts of misalignment along an X-direction and a Y-direction of the overlying layer and the underlying layer are detected by measuring distances 17, 18, 19 and 20 between edges of the marks 13 and 14.

The sizes of the conventional marks 13 and 14 ordinarily employed are 10 micrometers or more for easily conducting optical automatic measurement. These sizes are far more different from a size of the circuit pattern (1 micrometer or less). As a result, the amounts of misalignment between the marks are different from the misalignment between the underlying circuit pattern and the photoresist pattern due to aberration of a lens in a stepper.

Accordingly, even if how accurate the positioning of the conventional mark is adjusted, it has been difficult to accurately align the underlying layer circuit pattern and the overlying layer resist pattern.

### SUMMARY OF THE INVENTION

In view of the foregoing, an object of the present invention is to provide a reticle having a mark for detecting alignment and a method for detecting the alignment in which amounts of the misalignment of a circuit pattern and of the mark for detecting misalignment due to a lens aberration are made to be nearly equal by forming the circuit pattern and the mark both having similar sizes and similar pattern pitches.

The present invention provides, in a first aspect thereof, a reticle comprising a circuit pattern for exposing a wafer to form an exposed circuit pattern at a specified design rule, and an alignment mark for exposing the wafer to form an exposed alignment mark at said specified design rule.

The present invention provides, in a second aspect thereof, a method for exposing a wafer comprising the steps of forming a first circuit pattern on a first layer of the wafer and a first alignment mark in a marginal area of the wafer, said first alignment mark having a design rule substantially equal to a design rule of said first circuit pattern, forming a second circuit pattern on a second layer overlying said first layer and a second alignment mark in said marginal area of the wafer, said second alignment mark having a design rule substantially equal to the design rule of said first circuit pattern, and detecting an amount of misalignment between said first alignment mark and said second alignment mark.

In accordance with the present invention, an amount of misalignment between the circuit pattern of the underlying layer and the overlying resist pattern due to a lens aberration of a stepper employed for exposure can be accurately measured.

The above and other objects, features and advantages of the present invention will be more apparent from the following description.

### BRIEF DESCRIPTION OF DRAWINGS

Fig. 1 is a schematic view individually showing two box marks for automatically detecting misalignment between an underlying circuit layer and an overlying resist layer.
Fig.2 is a schematic view showing a state of the aligned box marks of Fig.1.
Fig.3 is a schematic view individually showing a mark for automatically detecting misalignment of an underlying circuit layer and that of a resist layer in accordance with the present invention.
Fig.4 is a schematic view showing a state of the aligned marks of the underlying circuit layer and the resist layer in Fig.3.
Fig.5 is a schematic view showing the mark of the present invention and a waveform obtained by monitoring a reflection ray from the mark.
Fig.6 is a schematic view individually showing the marks of the underlying circuit layer and the resist layer and box marks for the layers.
Fig.7 is a schematic view showing a state of the aligned marks and the aligned box marks in Fig.6.

### PREFERRED EMBODIMENTS OF THE INVENTION

Now, the present invention is more specifically described with reference to accompanying drawings.

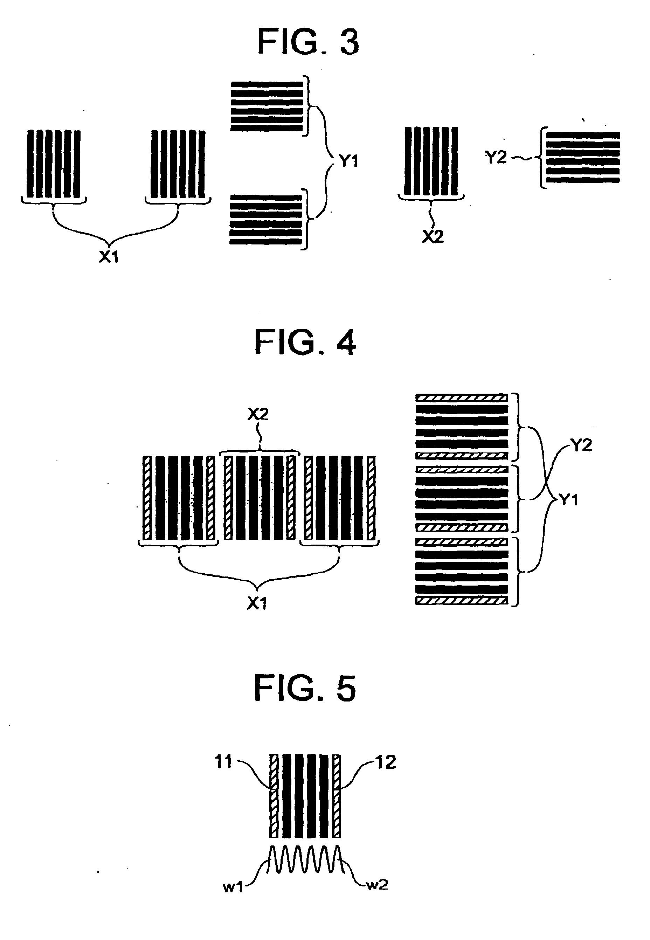

Fig.3 separately shows alignment marks X1 and Y1 (main scale) to be formed in the underlying layer having a circuit pattern and alignment marks X2 and Y2 (auxiliary scale) to be formed in a resist layer formed on the circuit pattern. More specifically, the marks in Fig.3 have a line-and-space pattern. These marks are formed by a plurality of parallel linear segments of which the line width and the line space are similar to those of the circuit pattern. The marks in Fig.3 have a line-and-space pattern. Thus, for a circuit pattern of 0.3 micrometer rule, the mark having a line-and-space pattern of which the line width and the line apace are 0.3 micronmeter is employed. The marks are formed in a marginal area outside the circuit pattern and the resist pattern.

The amount of misalignment due to lens aberration generated during transfer of a circuit pattern on a reticle to a wafer by a stepper is generally changed depending on the line width and the line space. A similar degree of influence due to the lens aberration received by the circuit pattern can be provided to the alignment marks by making the line width and the line space of the alignment marks similar to the line width and the line space of the circuit pattern. Thus, the amount of the misalignment of the circuit pattern can be accurately measured by using the alignment marks.

Fig.4 shows an aligned state of the alignment marks X1 and Y1 and the alignment marks X2 and Y2 on the marginal area or a state at a time of measuring an accuracy of alignment between the patterns of the overlying and underlying layers after the formation of the resist pattern of the overlying layer. The accuracy of the alignment in the X direction can be measured by detecting the positional relation between the alignment marks X1 and X2, and the accuracy of the alignment in the Y direction can be measured by detecting the positional relation between the marks Y1 and Y2.

An exemplified method for detecting the alignment by employing the alignment marks formed by the line-and-space pattern will be described referring to Fig.5.

When an alignment procedure is conducted by employing the television camera image of the alignment mark, the position measurement is performed by treating an optical wave signal shown in Fig.5. In the present embodiment, the position information in connection with the alignment marks is obtained from the waveform excluding partial waveforms w1 and w2 shown by the hatching and generated at lines 11 and 12 at the both ends from the optical signal waveform generated from the line-and-space pattern.

As described above, the amount of misalignment is changed depending on the line width and the line space. Since the alignment mark is formed as the line-and-space pattern as shown in Fig.3, the amount of the misalignment of the circuit pattern due to the lens aberration of the stepper can be accurately reflected to the alignment mark.

A main factor for generating the above stepper lens aberration which causes the misalignment of the patterns of which a degree is influenced by the line width and the line space is known to be a frame aberration. Since, however, in the present embodiment, the position measurement is conducted based on the waveform excluding the partial waveforms w1 and w2 generated at both end lines 11 and 12 of the line-and-space pattern, the lines 11 and 12 of which a shape may be changed due to the influence of the frame aberration can be neglected to accurately measure the minute misalignment due to the frame aberration.

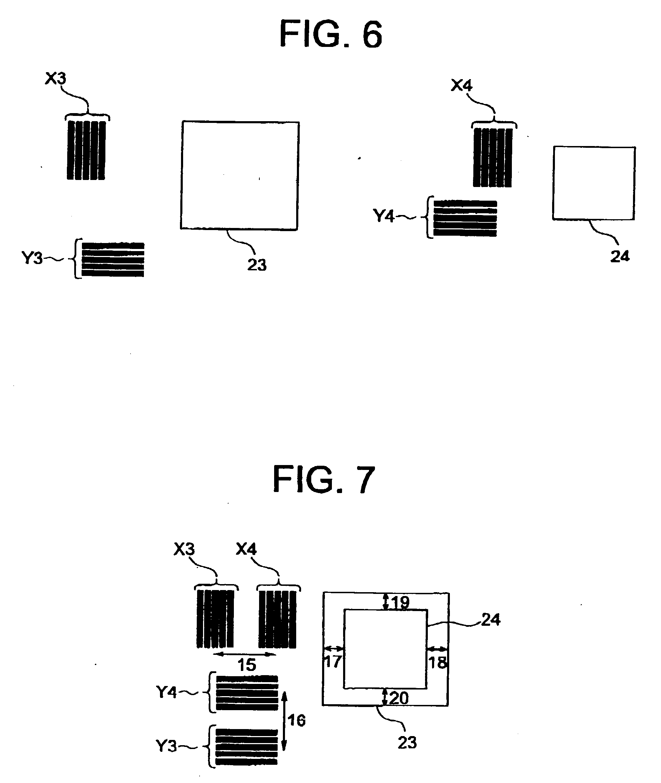

Another embodiment of a wafer having an alignment mark in which an amount of misalignment of a circuit pattern due to stepper lens aberration can be accurately measured will be described referring to Figs.6 and 7 in which X3, Ys and 23 are alignment marks on an underlying layer and X4, Y4 and 24 are alignment marks on a resist layer. The numerals 23 and 24 denote box marks for automatic measurement of misalignment generally employed, and the alignment marks X3 and X4 and the alignment marks X4 and Y4 disposed near the box marks 23 and 24, respectively, denote line-and space patterns having a line width substantially the same as that of the circuit pattern.

Since the box mark 23 and 24 generally employed have a size of 10 micrometers or more, an amount of misalignment thereof is much larger than that of a circuit pattern of which a line width is 1 micrometer or less. However, in the present embodiment, a difference between influences to the misalignment received by the alignment marks 23 and 24 and to that received by the alignment marks X3, Y3,X4 and Y4 can be measured in advance because the alignment marks X3, Y3,X4 and Y4 of the line-and-space patterns are disposed near the box marks 23 and 24.

In other words, the amounts of the misalignment in the X and Y directions of the circuit pattern can be accurately measured by automatically measuring the misalignment of the underlying layer and the resist layer aligned with each other by means of the conventional method employing the alignment marks 23 and 24 together with by measuring a distance 15 between the marks X3 and X4 and a distance 16 between the alignment marks Y3 and Y4 with a scanning electron microscope (SEM) as shown in Fig.7.

The difference between the result of the automatic measurement of the misalignment and the amount of the misalignment of the circuit pattern can be calculated from the difference between the result of the automatic measurement of the alignment marks 23 and 24 and measurement result of the distances 15 and 16 with SEM.

Once the measurement of the distances 15 and 16 with SEM is conducted, the amounts of the misalignment of the circuit pattern in the X and Y directions can be accurately measured in the following measurement only by the automatic measurement of the alignment marks 23 and 24 followed by simple addition of the difference, as an offset value, between the result of the automatic measurement and the measurement result of the distances 15 and 16.

The above method is effective when the direct and automatic measurement is difficult because the line-and-space patterns X3, Y3, X4 and Y4 having similar line widths to those of the circuit patterns are minute in sizes. The accurate measurement can be performed without changing the marks 23 and 24.

Since the above embodiments are described only for examples, the present invention is not limited to the above embodiments and various modifications or alternations can be easily made therefrom by those skilled in the art without departing from the scope of the present invention.

## Claims

1. A reticle comprising a circuit pattern for exposing a wafer to form an exposed circuit pattern at a specified design rule, and an alignment mark (X1, X2, Y1 and Y2) for exposing the wafer characterized in that said alignment mark (X1, X2, Y1 and Y2) forms an exposed alignment mark at said specified design rule.

2. The reticle as defined in claim 1, wherein said alignment mark (X1, X2, Y1 and Y2) includes a plurality of parallel segment marks having a line width and a line space equal to a line width and line space, respectively, of said circuit pattern.

3. The reticle as defined in claim 1 or 2, wherein said alignment marks (X1, X2, Y1 and Y2) include a first segment extending in a first direction and a second segment extending in a second direction perpendicular to said first direction.

4. The reticle as defined in claim 1, 2 or 3, wherein said alignment marks (X1, X2, Y1 and Y2) are formed as a line-and-space pattern.

5. A method for exposing a wafer characterized by comprising the steps of forming a first circuit pattern on a first layer of the wafer and a first alignment mark (X1 and Y1) in a marginal area of the wafer, said first alignment mark (X1 and Y1) having a design rule substantially equal to a design rule of said first circuit pattern, forming a second circuit pattern on a second layer overlying said first layer and a second alignment mark (X2 and Y2) in said marginal area of the wafer, said second alignment mark (X2 and Y2) having a design rule substantially equal to the design rule of said first circuit pattern, and detecting an amount of misalignment between said first alignment mark (X1 and Y1) and said second alignment mark (X2 and Y2).

6. The method as defined in claim 5, wherein said alignment marks (X1, X2, Y1 and Y2) are formed as a line-and-space pattern.

7. The method as defined in claim 6, wherein position information obtained at both ends of the line-and-space pattern is not employed for detecting the amount of misalignment.

8. The method as defined in one of claims 5 to 7, wherein the alignment between the first layer and the second layer is detected by employing the alignment marks (X1, X2, Y1 and Y2) together with box marks.
